# EUROPÄISCHE PATENTANMELDUNG

(11) **EP 2 161 763 A1**
(43) Veröffentlichungstag der Anmeldung: **10.03.2010**
(21) Anmeldenummer: 08015571.6
(22) Anmeldetag: 04.09.2008
(51) Int. Cl.: H01L 33/00, H05B 33/22

(54) **Konversionsfolie und ein Verfahren zu deren Herstellung**

(71) Anmelder: Bayer MaterialScience AG, 51368 Leverkusen (DE); LYTTRON Technology GmbH, 51061 Köln (DE)
(72) Erfinder: Maier-Richter, Andrea, Dr., 40699 Erkrath (DE); Foltin, Eckard, 53489 Sinzig (DE); Bernert, Thomas, Dr., 51377 Leverkusen (DE); Hedderich, Wilfried, 40724 Hilden (DE); Wagner, Thomas, 63594 Hasselroth (DE)
(74) Vertreter: Feldhues, Michael L.F.

(57) **Zusammenfassung**

Die Erfindung betrifft eine ein Konversionspigment enthaltende Konversionsfolie für ein lichtemittierendes Element, ein Verfahren zur Herstellung dieser Konversionsfolie, deren Verwendung und ein mit dieser Konversionsfolie ausgerüstetes lichtemittierendes Element.

## Beschreibung

Die Erfmdung betrifft eine Konversionspigmente enthaltende Konversionsfolie für ein lichtemittierendes Element, ein Verfahren zur Herstellung dieser Konversionsfolie, deren Verwendung und ein mit dieser Konversionsfolie ausgerüstetes lichtemittierendes Element.

Für den Einsatz in der Beleuchtung der menschlichen Umgebung (Umgebungsbeleuchtung) ist die Lichtindustrie insbesondere an Lichtquellen interessiert, die weißes Licht erzeugen, da dieses dem natürlichen Licht am ähnlichsten ist.

Aufgrund ihres geringen Energieverbrauchs und ihrer Langlebigkeit sind in den vergangenen Jahren vor allem LEDs, aber auch elektrolumineszente Lampen (Elektrolumineszens-Lampen, EL-Lampen), als Lichtquellen immer interessanter und beliebter geworden.

Diese Lichtquellen haben jedoch den Nachteil, dass sie nur monochromatisches Licht, d.h. Licht nur einer Lichtfarbe aussenden. Für LEDs sind dies insbesondere die Lichtfarben Blau, Grün, Gelb, Orange, Rot, Violett oder monochromatisches UV-Licht, UV-LEDs, für elektrolumineszente Lampen sind dies insbesondere die Lichtfarben Blau, Grün oder Orange.

Um diesem Nachteil abzuhelfen, werden beispielsweise weiße Lichtquellen auf Basis von LEDs durch die Kombination von blauen, grünen und roten LEDs hergestellt.

Alternativ werden organische oder anorganische Konversionspigmente eingesetzt, um mit den monochromatischen lichtemittierenden Elementen weißes Licht zu erzeugen. Dazu werden die lichtemittierenden Elemente mit Konversionspigmenten beschichtet. Dieses Verfahren kann sowohl bei LEDs als auch bei EL-Lampen angewendet werden.

Die Farbe des weißen Lichts (Lichttemperatur) einer solchen Lichtquelle ist dabei abhängig vom Konversionspigment, dessen Konzentration und von der ursprünglichen Wellenlänge der Strahlung des lichtemittierenden Elements. Die Homogenität des abgestrahlten Lichtes wird durch die Gleichmäßigkeit der Verteilung des Konversionspigments auf dem lichtemittierenden Element bestimmt.

So können beispielsweise Konversionspigmente einen Teil des beispielsweise blauen Lichts einer LED absorbieren und längerwelliges, gelbes Licht emittieren. Die additive Farbmischung aus dem übrig gebliebenen blauen Licht und dem durch die Farbschicht erzeugten gelben Licht ergibt für den Betrachter weißes Licht. Prinzipiell lässt sich der Farbort des ausgestrahlten Lichts auf einer Linie zwischen den Farborten der blauen LED und des Konversionspigments in der CIE 1931 Normfarbtafel einstellen. Die verwendeten UV-LEDs und blauen LEDs haben ein Emissionsmaximum im Bereich von 240 bis 510 nm, bevorzugt von 460 bis 475 nm, besonders bevorzugt von 464 nm.

Bei den derzeitigen Verfahren wird das Konversionspigment in eine Dispersion, beispielsweise mit Epoxyharzen oder Silikon, gebracht und auf das lichtemittierende Element, vorzugsweise eine LED, aufgetropft bzw. aufgesprüht, wodurch die Dispersion eine das Konversionspigment enthaltende Schicht auf dem lichtemittierenden Element bildet. Die auf Grund des Dispergierverfahrens ungleichmäßige, inhomogene Verteilung des Konversionspigments in der Dispersion und damit der daraus hervorgehenden Schicht bedingt eine inhomogene Abstrahlung des konvertierten Lichtes. Da das menschliche Auge für Farbunterschiede des weißen Lichtes besonders empfindlich ist, ist ein Sortieren (Binning) der lichtemittierenden Elemente nötig, um solche möglichst nur einer Lichtfarbe (Lichttemperatur) zu erhalten. Dieser nachgeschaltete Sortierprozess ist sehr ressourcenintensiv, da jedes einzelne lichtemittierende Element vermessen und entsprechend geclustert werden muss.

Aufgabe der Erfindung war es daher, die Nachteile des Standes der Technik zu überwinden. Insbesondere war es Aufgabe der Erfindung, ein Element zur Verfügung zu stellen, das die inhomogene Abstrahlung des konvertierten Lichtes vermeidet, also eine homogene Abstrahlung des konvertierten Lichtes gewährleistet. Dieses Element soll durch ein standardisiertes Verfahren reproduzierbar herstellbar sein und sich hinsichtlich der zu verarbeitenden Konversionspigmente und der damit verbundenen Lichtfarbe (Lichttemperatur) individualisieren lassen. Eine Konfektionierung des Elementes beispielsweise durch Schneiden oder Stanzen, soll anwendungsbezogen durch nachfolgende Fertigungsschritte auf einfache Weise möglich sein. Eine weitere Aufgabe der Erfindung war es, ein Verfahren zur Herstellung dieses Elementes zur Verfügung zu stellen.

Insbesondere wird die Aufgabe durch eine Konversionspigmente enthaltende Konversionsfolie gelöst, die homogene Konversionseigenschaften aufweist. Dies wird durch eine homogene Verteilung der Konversionspigmente in einer Konversionsschicht und/oder Konversionsschichten der Konversionsfolie über die gesamte(n) Schichtfläche(n) der Konversionsschicht(en) erreicht.

Gegenstand der Erfindung ist eine Konversionsfolie für ein lichtemittierendes Element enthaltend eine oder mehrere Konversionspigmente aufweisende Konversionsschichten B, bevorzugt ein, zwei, drei oder vier Konversionsschichten B1, B2, B3, B4, **dadurch gekennzeichnet, dass** in der oder den Konversionsschichten die Abweichungen in den Konversionseigenschaften von einem Messpunkt mit einer Größe von 0,005 bis 0,05 mm², bevorzugt von 0,01 bis 0,02 mm² zu einem anderen beliebigen Messpunkt derselben Größe, gleich oder kleiner als Δx = 0,2 und Δy = 0,2 in den Farbkoordinaten x und y im Farbraum CIE 1931, bevorzugt nicht größer als Δx = 0,035 und Δy 0,035, besonders bevorzugt nicht größer als Δx = 0,025 und Δy = 0,025, ganz besonders bevorzugt nicht größer als Δx = 0,017 und Δy = 0,017, sind.

Bevorzugt weist die Konversionsfolie zusätzlich ein Substrat A auf.

Erfmdungsgemäß bevorzugt hat die Konversionsfolie auch Licht streuende Eigenschaften, dient also auch als Streufolie.

Unter Streufolie wird dabei eine Folie mit der Fähigkeit verstanden, die Richtung der einfallenden Lichtstrahlen durch Lichtbrechung so umlenken zu können, dass das austretende Licht weitgehend diffus, d.h. gleichmäßig in alle Richtungen, abgestrahlt wird. Diese Fähigkeit kann beispielsweise durch die Rauhigkeit des Substrates oder durch Streupigmente erreicht werden. Diese Streupigmente können im Substrat oder einer beliebigen auf das Substrat aufgebrachten Schicht ein- oder aufgebracht sein. Dabei kann auch das Konversionspigment im Sinne der Erfindung als Streupigment dienen.

Unter Konversionsschicht im Sinne der Erfindung wird eine ein Konversionspigment enthaltende Schicht verstanden. Unter Konversionspigment im Sinne der Erfindung wird auch eine Mischung aus zwei oder mehreren verschiedenen Konversionspigmenten verstanden. Diese Konversionsschicht kann zusätzliche Streupigmente enthalten.

Homogen im Sinne der Erfindung bedeutet dabei, dass die Konversionseigenschaften über die gesamte Ausdehnung der mit Konversionspigment bedruckten Konversionsfolie gleich sind. Unter Konversionseigenschaften werden dabei der Transmissionsgrad für die Lichtwellenlänge des lichtemittierenden Elements sowie die Emmissionsgrade für die konvertierten Lichtwellenlängen verstanden. Die Konversionseigenschaften werden bestimmt, indem man mit einer Spektralkamera (beispielsweise mit einer LMK 98-4 von Techno Team) die spektrale Abstrahlcharakteristik des lichtemittierenden Elementes (Intensität in Abhängigkeit von der Wellenlänge) aufnimmt, und mit dem Spektraldiagramm mit eingelegter Konversionsfolie in Bezug auf den Farbort vergleicht. Alternativ kann ein digitales Foto (mit farbkalibrierter Kamera) bezüglich Intensität (Helligkeit) und Farbort ausgewertet werden.

Unter homogenen Konversionseigenschaften im Sinne der Erfmdung wird dabei insbesondere verstanden, dass die Abweichungen in den Konversionseigenschaften in der Konversionsschicht von einem Messpunkt mit einer Größe von 0,005 bis 0,05 mm² bevorzugt von 0,01 bis 0,02 mm² zu einem anderen beliebigen Messpunkt der selben Größe, gleich oder kleiner als Δx = 0,2 und Δy = 0,2 in den Farbkoordinaten x und y im Farbraum CIE 1931, bevorzugt nicht größer als Δx = 0,035 und Δy = 0,035, ganz besonders bevorzugt nicht größer als Δx = 0,025 und Δy = 0,025, ganz besonders bevorzugt nicht größer als Δx = 0,017 und Δy = 0,017 sind.

Die vorgenannten Eigenschaften gelten erfindungsgemäß vorzugsweise für eine gedruckte Konversionsfolie für die Bereiche, die mindestens etwa 5 bis 10 mm vom äußeren Rand des bedruckten Bereiches im mit Konversionspigment bedruckten Bereich der Konversionsfolie liegen, d.h. der innere Bereich der gedruckten Konversionsfolie, sowie auch für die gesamte fertige Konversionsfolie, da dieser innere Bereich der gedruckten Konversionsfolie frei von herstellungsbedingten Inhomogenitäten ist und die fertigen Konversionsfolien aus diesem inneren Bereich beispielsweise ausgeschnitten oder ausgestanzt werden.

Dies gilt wiederum vorzugsweise unter der Bedingung, dass die vom lichtemittierenden Element ausgesandte Strahlung im Wesentlichen senkrecht auf die Großfläche der Konversionsfolie fällt, wobei die Abweichung von der Senkrechten weniger als 30°, bevorzugt weniger als 15°, besonders bevorzugt weniger als 7,5° sein sollte.

Unter einer fertigen Konversionsfolie im Sinne der Erfmdung wird dabei eine Konversionsfolie verstanden, mit der das lichtemittierende Element ausgerüstet werden kann, um monochromatisches Licht in weißes Licht umzuwandeln, d.h. die Konversionsfolie nach Abschluss der Herstellung, einschließlich der Konfektionierung. Bei der Konfektionierung kann die Konversionsfolie durch Verfahren wie Schneiden oder Stanzen, sei es mechanisch, thermisch, durch Werkzeuge, Laser, Flüssigkeiten, Druckgase etc. bearbeitet werden.

Im Sinne der Erfmdung wird die Konversionsfolie, die vor der Konfektionierung erhalten wird, als gedruckte Konversionsfolie bezeichnet.

Sind die Merkmale der gedruckten und fertigen Konversionsfolie gleich, wird für beide nur der Ausdruck Konversionsfolie verwendet.

Unter dem Begriff "lichtemittierendes Element" werden im Sinne der Erfmdung verstanden:
- lichtemittierende Halbleiterelemente, vorzugsweise LED, OLED, PLED;
- elektrolumineszente Elemente, vorzugsweise anorganische und/oder organische Dickschichtund/oder Dünnschichtelemente.

Die Konversionsschicht der Konversionsfolie wird vorzugsweise durch Auftragsverfahren auf ein Substrat hergestellt, beispielsweise durch Druckverfahren wie Siebdruck, Flexo- oder Gravurdruck, oder durch Filmgießen oder Guss-Streichverfahren. Wiederum vorzugsweise wird die Konversionsschicht durch ein Siebdruckverfahren, wiederum vorzugsweise durch Flachbett- und Rotations-Siebdruck hergestellt. Insbesondere mit Druckverfahren, wiederum insbesondere mit Siebdruckverfahren lassen sich standardisierte, gut reproduzierbare und homogene Schichten herstellen. Die gedruckte Konversionsfolie kann beispielsweise in Form von Bogen- oder Rollenware als Halbzeug in allen anwendungstechnisch möglichen Abmessungen erhalten und für die weitere Konfektionierung eingesetzt werden.

Soweit technisch sinnvoll, können auch weitere Schichten der Konversionsfolie, insbesondere transluzente Farbschichten, durch Auftragsverfahren hergestellt werden.

Die Fläche des Substrats, die während der Herstellung der gedruckten Konversionsfolie durch Auftrageverfahren mit Konversionspigment beschichtet wird, und damit folglich die Fläche der gedruckten Konversionsfolie, ist um ein vielfaches größer ist als die Fläche der fertigen Konversionsfolie, also der Konversionsfolie nach der Konfektionierung. Da die Konversionsfolie vorzugsweise vollkommen eben ist, treten hinsichtlich der homogenen Verteilung des Konversionspigments in der fertigen Konversionsfolie keinerlei Randeffekte auf. Dies gilt insbesondere unter der Voraussetzung, dass die fertige Konversionsfolie aus dem inneren Bereich der gedruckten Folie entnommen, also bespielsweise ausgeschnitten oder ausgestanzt wird. Sowohl für die fertige Konversionsfolie als auch für den inneren Bereich der gedruckten Konversionsfolie gilt, dass eine homogene Verteilung des Konversionspigments und eine konstante Schichtdicke vorliegen, woraus sich die homogenen Konversionseigenschaften ergeben.

Die erfindungsgemäße Konversionsfolie macht ein Sortieren der lichtemittierenden Elemente überflüssig, da die Konversionspigmente gleichmäßig in der Konversionsschicht verteilt sind. Die Pigmente agglomerieren nicht in der Schicht. An jeder Stelle der fertigen Konversionsfolie findet man im Mittel die gleiche Konzentration von Pigmenten vor, so dass alle lichtemittierenden Elemente, die mit der erfindungsgemäßen Konversionsfolie ausgerüstet sind, die gleiche Lichtfarbe (Lichttemperatur) aufweisen. Bei lichtemittierenden Elementen, die nach Verfahren aus dem Stand der Technik mit einer Konversionspigment enthaltenden Schicht ausgerüstet sind, ist dies nicht sichergestellt.

Eine Qualitätsprüfung sowohl der gedruckten als auch der fertigen erfmdungsgemäßen Konversionsfolie ist sowohl in-line wie off-line wirtschaftlich möglich. Die endgültige Farbtemperatur wird durch die Art des Konversionspigments, den Füllgrad der Konversionsschicht, die Dicke der Konversionsschicht, die Anzahl der Schichten, die aufgebracht werden, sowie der Ursprungsemissionswellenlänge des lichtemittierenden Elements bestimmt. Diese Farbtemperatur wird nach Abschluss des Verfahrens ermittelt und ist bei gleichen Verfahrensbedingungen reproduzierbar.

Um das Tagdesign des lichtemittierenden Elemens frei wählen zu können, kann die mit der Konversionsschicht bedruckte Konversionsfolie zusätzlich mit einer transluzenten Farbschicht versehen sein. Beispielsweise ist die Konversionsschicht der erfindungsmäßen Erfindung gelb gefärbt, um bei einer blauen LED als lichtemittierendes Element weißes Licht zu erzeugen, oder sie hat eine andere Farbe, um beliebige Farben mit den drei Grundfarben beispielsweise einer LED (Rot, Blau und Grün) zu erzeugen. Unter transluzent wird dabei erfindungsgemäß eine Lichttransmission von höher als 20 %, bevorzugt höher als 30 % und besonders bevorzugt von über 40 % des eingestrahlten Lichts verstanden. Die Farbe der transluzenten Farbschicht kann beliebig gewählt werden. Transluzente Farben sind im Stand der Technik und dem Fachmann bekannt, beispielsweise Farben der Fa. Pröll KG. Diese Beschichtung kann auf die Konversionsschicht aufgebracht werden oder aber auf die Seite des Substrates A, die der Konversionsschicht abgewandt ist. Es ist dabei zu beachten, dass die transluzente Farbschicht vom lichtemittierenden Element aus betrachtet möglichst hinter der der Konversionsschicht liegt.

Die transluzente Farbschicht kann jedoch auch auf eine separate Folie aufgebracht werden. Diese Folie, die auch streuende Eigenschaften haben kann, kann dann auf die Seite der Konversionsfolie angebracht werden, die vom lichtemittierenden Element abgewandt ist. Dies kann unmittelbar oder mittelbar durchgeführt werden, beispielsweise mittels einer haftvermittelnden Schicht, wie z.B. einem Klebstoff oder einer laminierbaren (Klebe)Schicht. Auf eine transluzente Farbschicht auf der Konversionsfolie kann dann verzichtet werden. Alternativ kann die die transluzente Farbschicht aufweisende Folie jedoch auch so über der Konversionsfolie angebracht werden, dass sich zwischen den beiden Folien ein Gas, bevorzugt Luft, befindet. Dies hat den Vorteil, dass die Konversionsschicht durch die transluzente Farbschicht kaum noch wahrzunehmen ist. Auf eine transluzente Farbschicht auf der Konversionsfolie kann auch in diesem Fall verzichtet werden.

Die erfindungsgemäße Konversionsfolie umfasst ein Substrat A und eine oder mehrere Konversionsschichten B, bevorzugt ein, zwei, drei oder vier Konversionsschichten B1, B2, B3 oder B4.

Die Konversionsfolie kann darüber hinaus gegebenenfalls noch folgende Schichten enthalten: eine oder mehrere Schutzschichten C, bevorzugt ein, zwei, drei oder vier Schutzschichten C1, C2, C3 oder C4, gegebenenfalls eine oder mehrere transluzente Farbschichten D, bevorzugt ein, zwei, drei oder vier transluzente Farbschichten D1, D2, D3 oder D4, gegebenenfalls eine oder mehrere Grafikschichten E, bevorzugt ein oder zwei Grafikschichten E1, E2. Gegebenenfalls kann mindestens eine der vorgenannten Schichten mit mindestens einer anderen der vorgenannten Schichten und/oder mit dem Substrat A und/oder mit einer Abdeckfolie durch eine oder mehrere Zwischenschichten, vorzugsweise eine oder mehrere Haftvermittlungsschichten verbunden sein.

Bevorzugt weist die Konversionsfolie folgenden Aufbau auf:
Ausführungsform I
   - Die Konversionsfolie ist auf der Seite, die dem lichtemittierenden Element abgewandt ist, folgendermaßen aufgebaut:
      1) Substrat A;
      2) darauf eine oder mehrere Konversionsschichten B;
      3) darauf gegebenenfalls eine oder mehrere transluzente Farbschichten D;
      4) darauf gegebenenfalls eine oder mehrere Schutzschichten C und/oder eine Abdeckfolie; und das Substrat A weist auf der Seite, die dem lichtemittierenden Element zugewandt ist, gegebenenfalls eine oder mehrere Schutzschichten C und/oder eine Abdeckfolie auf;
         oder
Ausführungsform II
   - Die Konversionsfolie ist auf der Seite, die dem lichtemittierenden Element zugewandt ist, folgendermaßen aufgebaut:
      1) Substrat A;
      2) darauf gegebenenfalls eine transluzente oder mehrere transluzente Farbschichten D;
      3) darauf eine oder mehrere Konversionsschichten B;
      4) darauf gegebenenfalls eine oder mehrere Schutzschichten C und/oder eine Abdeckfolie;
         und das Substrat A weist auf der Seite, die dem lichtemittierenden Element abgewandt ist, folgenden Aufbau auf:
      6) gegebenenfalls eine oder mehrere transluzente Farbschichten D;
      7) darauf gegebenenfalls eine oder mehrere Schutzschichten C und/oder eine Abdeckfolie;
         oder
Ausführungsform III
   - Die Konversionsfolie ist auf der Seite, die dem lichtemittierenden Element zugewandt ist, folgendermaßen aufgebaut:
      1) Substrat A;
      2) darauf gegebenenfalls eine oder mehrere transluzente Farbschichten D;
      4) darauf eine oder mehrere Konversionsschichten B;
      5) darauf gegebenenfalls eine oder mehrere Schutzschichten C und/oder eine Abdeckfolie; und das Substrat A weist auf der Seite, die dem lichtemittierenden Element abgewandt ist, gegebenenfalls eine oder mehrere Schutzschichten C und/oder eine Abdeckfolie auf.

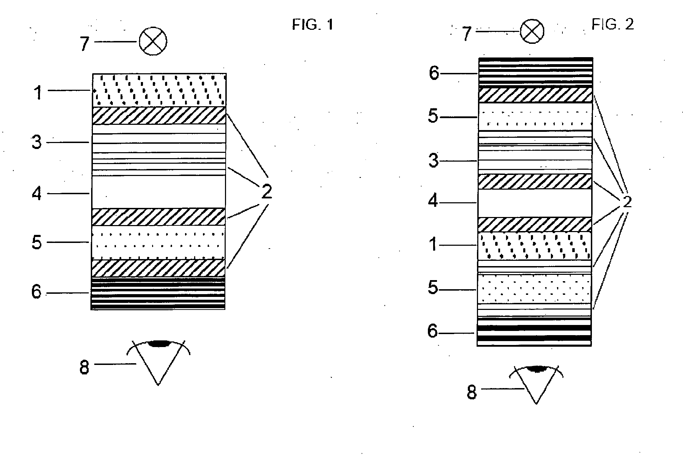

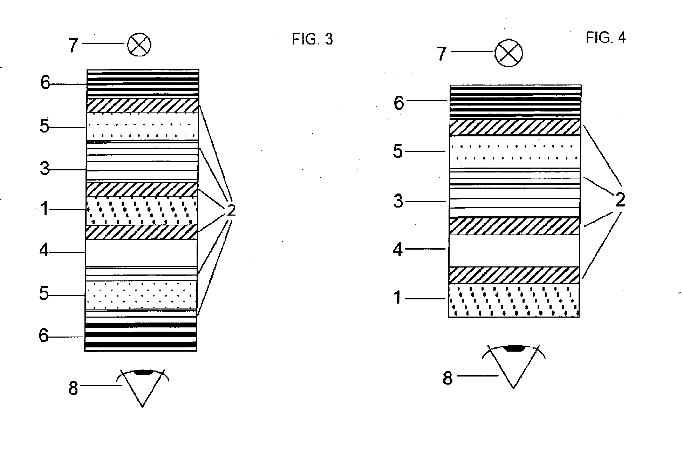

Beispielhafte Ausführungsformen können den Figuren 1 bis 4 entnomnen werden.

Die Grafikschicht(en) sind vorzugsweise auf der Seite der Konversionsschicht(en) angebracht, die dem lichtemittierenden Element abgewandt ist.

Vorzugsweise ist das Substrat A eine Folie mit einer Dicke von 10 µm bis 2.000 µm, bevorzugt von 70 µm bis 500 µm, besonders bevorzugt 100 µm bis 375 µm, ganz besonders bevorzugt 125 µm bis 275 µm.

Vorzugsweise ist das Substrat A eine Platte mit einer Dicke von 500 µm bis 10.000 µm, bevorzugt von 750 µm bis 6.000 µm, besonders bevorzugt 2.000 µm bis 5.000 µm.

Das Substrat A besteht im Wesentlichen aus Glas, beispielsweise einer Glasscheibe oder einer Glaslinse, oder aus einem vorzugsweise als Folie oder Platte ausgebildeten polymeren Material, vorzugsweise ausgewählt aus der Gruppe bestehend aus den Polymeren Polyethylen (PE), Polypropylen (PP), Polyethylenterephthalat (PET), Cellulosetriacetat (CTA), Ethylenvinylacetat (EVA), Polyvinylacetat (PVA), Polyvinylalkohol, Polyvinylbutyral (PVB), Polyvinylchlorid (PVC), Polyester, Polycarbonat (PC), Polyethylennaphthalat (PEN), Polyurethane (PU), Thermoplastische Polyurethane (TPU), Polyamide (PA), Polymetylmethacrylat (PMMA), Cellulosenitrat und/oder Copolymeren aus mindestens zwei der Monomere der vorgenannten Polymere und/oder Mischungen aus zwei oder mehreren dieser Polymere. Die Transparenz der genannten Materialien sollte 50 %, bevorzugt 70 %, besonders bevorzugt 90 % nicht unterschreiten. Beliebige andere hinreichend transparente Materialien außer den genannten sind ebenfalls geeignet.

Im Falle einer beabsichtigten dreidimensionalen Verformung der Konversionsfolie sollte das Substrat vorzugsweise aus mindestens einem kalt reckbaren Folienmaterial aufgebaut sein. Dadurch ist eine isostatische Hochdruckverformung bei einer Verfahrenstemperatur unterhalb der Erweichungstemperatur des Substrats möglich. Geeignete kalt reckbare Folienmaterialien sind zum Beispiel in EP-A-0 371 425 genannt. Es können sowohl thermoplastische als auch duroplastische, zumindest teilweise transparente, kalt reckbare Folienmaterialien eingesetzt werden. Bevorzugt werden kalt reckbare Folienmaterialien eingesetzt, die bei Raum- und Gebrauchstemperatur ein geringes oder kein Rückstellvermögen aufweisen. Besonders bevorzugte Folienmaterialien sind ausgewählt aus mindestens einem Material aus der Gruppe bestehend aus Polycarbonaten, bevorzugt Polycarbonaten auf Basis von Bisphenol A, beispielsweise die von Bayer MaterialScience AG vertriebenen Makrofol^{®}-Typen, aus Polyestern, insbesondere aromatischen Polyestern, beispielsweise Polyalkylenterephthalaten, aus Polyamiden, beispielsweise PA 6 oder PA 6,6-Typen, aus hochfesten "Aramid-Folien", aus Polyimiden, beispielsweise Folien auf Basis von Poly (diphenyloxidpyromellitimid), Polyarylaten, organischen thermoplastischen Celluloseestern, insbesondere deren Acetaten, Propionaten und Acetobutyraten und Polyfluorkohlenwasserstoffen, insbesondere Copolymerisate aus Tetrafluorethylen und Hexafluorpropylen, die in transparenter Ausführungsform verfügbar sind. Bevorzugte Folienmaterialien sind ausgewählt aus Polycarbonaten, beispielsweise die von Bayer MaterialScience AG vertriebenen Makrofol^{®}-Typen, Polyestern, insbesondere aromatischen Polyestern, beispielsweise Polyalkylenterephthalaten und Polyimiden, Folien auf der Basis von Poly (diphenyloxid pyromellith imid). Ganz besonders bevorzugt werden als Folienmaterialien Polycarbonate auf der Basis von Bisphenol A eingesetzt, insbesondere Folien mit der Bezeichnung Bayfol^{®} CR (Polycarbonat/Polybutylenterephthalat-Folien), Makrofol^{®} TP oder Makrofol^{®} DE der Bayer MaterialScience AG.

Als Konversionspigment eignen sich sowohl organische als auch anorganische Pigmente. Als organische Pigmente können beispielsweise sogenannte Tagesleuchtpigmente wie die T-Serien oder FTX Serien von Swada oder die Tagesleuchtpigmente von Sinloihi, wie z.B. die FZ-2000 Serien, FZ-5000 Serien, FZ-6000 Serien, FZ-3040 Serien, FA-40 Serien, FA-200 Serien, FA-000 Serien, FM-100, FX-300 oder SB-10 verwendet werden.

Als Materialien für anorganische Pigmente können Granate oder Oxinitride verwendet werden, wie beispielsweise (Y, Gd, Lu, Tb)3(Al, Ga)5O12 dotiert mit Ce, (Ca, Sr, Ba)2SiO4 dotiert mit Eu, YSiO2N dotiert mit Ce, Y2Si3O3N4 dotiert mit Ce, Gd2Si3O3N4 dotiert mit Ce, (Y, Gd, Tb, Lu)3Al5-xSixOl2-xNx dotiert mit Ce, BaMgA110O17 dotiert mit Eu, SrAl2O4 dotiert mit Eu, Sr4Al14O25 dotiert mit Eu, (Ca, Sr, Ba)Si2N2O2 dotiert mit Eu, SrSiAl2O3N2 dotiert mit Eu, (Ca, Sr, Ba)2Si2N8 dotiert mit Eu, CaAlSiN3 dotiert mit Eu; Molybdate, Wolframate, Vanadate, Nitride und/oder Oxide des Bors, Aluminiums, Galliums, Indiums und Thalliums, jeweils einzeln oder Mischungen davon mit einem oder mehreren Aktivatorionen wie Ce, Eu, Mn, Cr und/oder Bi.

Umfasst die Konversionsfolie mehrere Konversionsschichten, so können die verschiedenen Schichten auch verschiedene Konversionspigmente enthalten, sie können aber auch alle das gleiche Konversionspigment enthalten.

Die Dicke der Konversionsschicht bzw. die Summe der Dicken der Konversionsschichten beträgt 1 bis 300 µm, bevorzugt 20 bis 200 µm, besonders bevorzugt 50 bis 100 µm, wobei die Dicke einer einzelnen Schicht vorzugsweise 1 µm nicht unterschreitet. Eine einzelne Schicht kann in einem einzigen Auftrags-, insbesondere Druckvorgang aufgebracht werden, oder in mehreren Druckvorgängen. Bei höheren Füllgraden an Konversionspigment in der bzw. den Konversionsschicht(en) kann die Dicke der Konversionsschicht bzw. die Summe der Dicken der Konversionsschichten bei gleichen Konversionseigenschaften geringer gehalten werden als bei niedrigeren Füllgraden.

Bei einem Füllgrad von beispielsweise 40 Gew.-% an Konversionspigment in der Druckpaste zur Herstellung der Konversionsschicht beträgt die Dicke der Konversionsschicht bevorzugt etwa 75 bis 95 µm, um das blaue Licht einer LED, beispielweise mit einer Strahlung von 464 nm Wellenlänge, zu einem für den Betrachter weißen Licht zu konvertieren.

Zur Herstellung der vorgenannten Druckpaste für die Konversionsschicht werden Lackrohstoffe beispielsweise auf Basis von Polyurethanen verwendet, insbesondere Desmodur^{®} und/oder Desmophen^{®} sowie Bayhydur^{®} und Bayhydrol^{®} der Fa. Bayer MaterialScience AG. Außerdem können auch fertige, nicht pigmentierte Siebdruckpasten von Firmen wie beispielsweise Pröll, Marabu, Coates Screen, DuPont etc. (3M Scotcheal^{®} und Scotchlite^{®} verwendet werden. Diese Lacke, Pasten oder Rohstoffformulierungen werden mit 1 bis 99 Gew.-%, bevorzugt mit 10 bis 80 Gew.-%, besonders bevorzugt mit 20 bis 77 Gew.-%, ganz besonders bevorzugt mit 35 bis 72 Gew.-% der oben beschriebenen Konversionspigmente gefüllt. Um die richtige Viskosität für den Siebdruck einzustellen, können die Pasten mit geeigneten Lösungsmitteln verdünnt werden, beispielsweise mit Wasser, Ethylacetat, Butylacetat, 1-Methoxypropylacetat-2, Toluol, Xylol, Solvesso 100, Shellsol A oder Mischungen aus zwei oder mehreren dieser Lösemittel. Als Bindemittel können Ein- oder bevorzugt Zweikomponentenpolyurethansysteme verwendet werden, beispielsweise von der Fa. Bayer MaterialScience AG (z.B. Desmodur^{®} und/oder Desmophen^{®}) oder Bindemittel auf der Grundlage von Polyvinylbutyral, beispielsweise dem als Mowital^{®} vertriebenen Material von Kuraray Europe GmbH, oder Polymethylmethacrylat. Weiterhin können der Paste noch Additive wie Verlaufsmittel und Rheologieadditive zur Verbesserung der Eigenschaften zugefügt werden.

Beispielsweise enthält eine Formulierung zur Herstellung einer Konversionsschicht im Siebdruckverfahren 40,2 Gew.-% Konversionspigmente, (Ca, Sr, Ba)₂SiO₄ dotiert mit Eu von Leuchtstoffwerke Breitungen, 45,9 Gew.-% Noriphan^{®} HTR 093 von der Firma Pröll und 13,9 Gew.-% Noriphan^{®} HTR 097 von der Firma Pröll. Eine andere erfindungsgemäße Formulierung enthält beispielsweise 39,2 Gew.-% Konversionspigmente(Ca, Sr, Ba)₂SiO₄ dotiert mit Eu von Leuchtstoffwerke Breitungen, 44,8 Gew.-% Noriphan^{®} HTR 093 von der Firma Pröll und 16,0 Gew.-% Noriphan^{®} HTR 097 von der Firma Pröll.

Erfindungsgemäß können auch UV-trocknende Lacksysteme zur Herstellung der Konversionsschicht eingesetzt werden. So können beispielsweise 100%ige, lösemittelhaltige oder wässrige UVhärtende Polyurethanlacke eingesetzt werden. Diese haben den Vorteil, dass sie flexibel sind und somit für später zu verformende Teile besonders geeignet sind.

Ein weiterer Gegenstand der Erfmdung ist ein Verfahren zur Herstellung der erfindungsgemäßen Konversionsfolie. Wie bereits erwähnt, kann die Konversionsfolie durch die bekannten Auftragsverfahren hergestellt werden. Vorzugsweise wird sie durch Druckverfahren, insbesondere Siebdruck hergestellt. Druckverfahren sind, im Vergleich zu den herkömmlichen Dispersionsverfahren, standardisiert und reproduzierbar.

Bevorzugt umfasst das Verfahren folgende Schritte:
(1) Vorlegen des Substrates A, vorzugweise als Bogen oder von einer Rolle;
(2) Aufbringen des in einer Paste dispergierten Konversionspigments, bevorzugt im Siebdruckverfahren zur Herstellung der Konversionsschicht B;
(3) Trocknen und/oder Polymerisieren und/oder Vernetzen der Konversionsschicht B auf dem Substrat A.

Zum Siebdruck kann beispielsweise ein Sieb der Siebfeinheit 43 Fäden/inch verwendet werden. Weitere brauchbare Siebfeinheiten liegen zwischen 20 und 120 Fäden/inch, insbesondere bei 25, 36, 68, 77, 90, 120 Fäden/inch.

Die Schritte (1), (2) und (3) werden vorzugsweise in dieser Reihenfolge nacheinander ausgeführt.

Der vorgenannte Schritt (2) oder der vorgenannte Schritt (3) oder die Schritte (2) und (3) können jeweils einzeln und/oder im Wechsel ein-, zwei-, drei- oder mehrfach wiederholt werden, wobei die erste Ausführung des Schrittes (2) auf den Schritt (1) folgt.

Zum Einstellen des Farbortes des mit der Konversionsfolie ausgerüsteten lichtemittierenden Elements kann die Anzahl der Druckschichten für eine einzelne Konversionsschicht und/oder die Anzahl der Konversionsschichten ausgewählt werden. So kann bei einer einzelnen Konversionsschicht nur eine Schicht gedruckt werden oder es können zwei, drei, vier oder fünf Druckschichten nass oder nass in nass übereinander gedruckt werden. Der Füllgrad an Konversionspigment innerhalb einer einzelnen Schicht kann gleich oder unterschiedlich zu dem Füllgrad einer oder mehrerer anderer Schichten sein. Dies ermöglicht es, den Farbort genau einzustellen.

Die weiteren Schichten, die die Konversionsfolie enthalten kann, können durch beliebige Verfahren gemäß dem Stand der Technik aufgebracht werden, wobei bevorzugt Siebdruckverfahren angewendet werden, soweit dies technisch sinnvoll und möglich ist.

Nach Fertigstellung der gedruckten Konversionsfolie können aus dieser, erfindungsgemäß bevorzugt aus deren inneren Bereich, die fertigen Konversionsfolien durch Konfektionierung erhalten werden. Die fertigen Konversionsfolien haben gemeinhin in der technischen Ausführung eine Fläche von 1 bis 100 mm² , bevorzugt 2 bis 50 mm², besonders bevorzugt von 4 bis 25 mm², jedoch ist es möglich, sowohl größere als auch kleinere Konversionsfolien auszuschneiden, abhängig vom Konfektionierungsverfahren und der gewünschten Anwendung. Die erfindungsgemäße fertige Konversionsfolie kann beliebig auf oder über einem lichtemittierenden Element im Strahlengang des Lichtes auf- und/oder angebracht werden. So ist es möglich, sowohl eine einzelne kleine LED mit einer Konversionsfolie abzudecken als auch ganze Flächen mit LED-Feldern oder auch großflächige EL-Lampen abzudecken.

Weiterhin ist es möglich, ein lichtemittierendes Element mit mehr als einer Konversionsfolie mit einer oder mehreren Konversionsschichten auszurüsten, falls ein mehrschichtiger Aufbau gewünscht oder benötigt wird.

In einer alternativen Ausführungsform der Erfmdung kann das Substrat A nach dem Auftragen der Konversionsschicht(en) und gegebenenfalls einer oder mehrerer der Schichten ausgewählt aus Zwischenschicht(en), transluzente(n) Farbschicht(en), Schutzschicht(en), Schutzfolie(n) entfernt werden. Die Konversionsfolie wird dann aus der oder den aufgebrachten Schicht(en) gebildet. Diese Schicht(en) übernehmen dann die Aufgabe(n) des Substrats A (beispielsweise die tragende/stützende und/oder die ggf. streuende Wirkung des Substrats A). Im Sinne der Erfmdung stellt bzw. stellen diese Schicht(en) für diese alternative Ausführungsform nach Entfernung des ursprünglichen Substrats A die Konversionsfolie dar. So kann bei geeigneten Materialien die Konversionsfolie beispielsweise nur aus der Konversionsschicht bestehen, wobei diese sowohl die Funktion des Substrates A als auch die der Konversionsschicht B übernimmt. Vorzugsweise wird das Substrat A nach einem der Trocknungs-, Polymerisations- und/oder Vernetzungsschritte (3) entfernt, wiederum vorzugsweise nach dem letzten Schritt (3).

Ein weiterer Gegenstand der Erfmdung ist die Verwendung der erfindungsgemäßen Konversionsfolie zur Ausrüstung von lichtemittierenden Elementen, insbesondere lichtemittierenden Halbleiterelementen, vorzugsweise LED (light emitting device, lichtemittierendes Element), OLED (organic light emitting device, organisches lichtemittierendes Element), PLED (polymer light emitting device, polymeres lichtemittierendes Element).und elektrolumineszenten Elementen, vorzugsweise anorganischen und/oder organischen Dickschicht- und/oder Dünnschichtelementen.

Ein weiterer Gegenstand der Erfindung ist eine Vorrichtung enthaltend ein lichtemittierendes Element, welches dadurch gekennzeichnet ist, dass das lichtemittierende Element mit mindestens einer erfindungsgemäßen Konversionsfolie ausgerüstet ist, vorzugsweise abgedeckt ist. Dieses mit der erfindungsgemäßen Konversionsfolie ausgerüstete lichtemittierende Element kann zusätzlich noch mit einer eine transluzente Farbschicht umfassenden Folie ausgerüstet sein und zusätzlich streuende Eigenschaften aufweisen.

Unter "abgedeckt" im Sinne der Erfindung wird verstanden, dass das für die Anwendung genutzte Licht die Konversionsfolie durchstrahlt. Dabei wird das Licht ganz oder teilweise farbkonvertiert. Die Konversionsfolie kann direkt mit einem transparenten Kleber auf das lichtemittierende Element aufgeklebt oder an einem Gehäuse, in dem sich das lichtemittierende Element befindet, angebracht werden, beispielsweise durch Kleben, Stecken oder ein anderes mechanisches Befestigungsverfahren, oder auf einer Platine oder flexiblen Leiterbahn in geeigneter Weise angebracht werden, auf der sich das lichtemittierende Element befindet.

Insbesondere im Falle einer dreidimensional verformten Konversionsfolie kann diese auch auf das Gehäuse des lichtemittierenden Elementes geschraubt werden.

Zwischen lichtemittierendem Element und Konversionsfolie können sich eine oder mehrere weitgehend transparente Kleberschichten, weitere Folienschichten oder Luft befinden.

Die endgültige Farbtemperatur wird durch die Art des Konversionspigments, die Anzahl und Dicke der Konversionsschicht(en), der geometrischen Form der zwei- bzw. dreidimensional ausgestalteten Konversionsfolie sowie der Ursprungsemissionswellenlänge des lichtemittierenden Elements bestimmt. Diese Farbtemperatur wird ermittelt, nachdem das lichtemittierende Element mit der erfindungsgemäßen Konversionsfolie und ggf. mit einer eine transluzente Farbschicht umfassende Folie ausgerüstet wurde, und ist bei gleichen Verfahrensbedingungen reproduzierbar.

### Bezugszeichenliste:

- 1: Substrat A
- 2: Zwischenschicht(en)
- 3: Konversionsschicht B
- 4: Transluzente Farbschicht D
- 5: Schutzschicht C
- 6: Schutzfolie
- 7: lichtemittierendes Element
- 8: Betrachter

## Patentansprüche

1. Konversionsfolie für ein lichtemittierendes Element enthaltend eine oder mehrere Konversionspigmente aufweisende Konversionsschichten B, **dadurch gekennzeichnet, dass** in der Konversionsschicht die Abweichungen in den Konversionseigenschaften von einem Messpunkt mit einer Größe von 0,005 bis 0,05 mm² zu einem anderen beliebigen Messpunkt derselben Größe, gleich oder kleiner als Δx = 0,2 und Δy = 0,2 in den Farbkoordinaten x und y im Farbraum CIE 1931 sind.

2. Konversionsfolie nach Anspruch 1, **dadurch gekennzeichnet, dass** die Konversionsfolie zusätzlich ein Substrat A aufweist.

3. Konversionsfolie nach Anspruch 1 oder 2, **dadurch gekennzeichnet, dass** die Konversionsfolie zusätzlich zu der oder den Konversionsschicht(en) B eine oder mehrere Schutzschichten C und/oder eine Abdeckfolie aufweist.

4. Konversionsfolie nach einem der Ansprüche 1 bis 3, **dadurch gekennzeichnet, dass** die Konversionsfolie zusätzlich zu der oder den Konversionsschicht(en) B eine oder mehrere transluzente Farbschichten D aufweist.

5. Konversionsfolie nach einem der Ansprüche 1 bis 4, **dadurch gekennzeichnet, dass** die Konversionsfolie zusätzlich zu der oder den Konversionsschicht(en) B eine oder mehrere Grafikschichten E aufweist.

6. Konversionsfolie nach einem der Ansprüche 2 bis 5, **dadurch gekennzeichnet, dass** das Substrat A eine Folie mit einer Dicke von 10 µm bis 2.000 µm, bevorzugt von 70 µm bis 500 µm, besonders bevorzugt 100 µm bis 375 µm, ganz besonders bevorzugt 125 µm bis 275 µm ist.

7. Konversionsfolie nach einem der Ansprüche 2 bis 5, **dadurch gekennzeichnet, dass** das Substrat A eine Platte mit einer Dicke von 500 µm bis 10.000 µm, bevorzugt von 750 µm bis 6.000 µm, besonders bevorzugt 2.000 µm bis 5.000 µm ist.

8. Konversionsfolie nach einem der Ansprüche 1 bis 7, **dadurch gekennzeichnet, dass** die Dicke der Konversionsschicht bzw. die Summe der Dicken der Konversionsschichten 1 bis 300 µm, bevorzugt 20 bis 200 µm, besonders bevorzugt 50 bis 100 µm beträgt, wobei die Dicke einer einzelnen Schicht vorzugsweise 1 µm nicht unterschreitet.

9. Verfahren zur Herstellung einer Konversionsfolie nach einem der Ansprüche 1 bis 8, umfassend folgende Schritte:
(1) Vorlegen von Substrat A;
(2) Aufbringen des Konversionspigments im Siebdruckverfahren zur Herstellung einer Konversionsschicht B;
(3) Trocknen und/oder Polymerisieren und/oder Vernetzen des mit der Konversionsschicht B beschichteten Substrats A.

10. Verfahren nach Anspruch 9, **dadurch gekennzeichnet, dass** der Schritt (2) oder der Schritt (3) oder die Schritte (2) und (3) jeweils einzeln und/oder im Wechsel ein-, zwei-, drei- oder mehrfach wiederholt werden, wobei die erste Ausführung des Schrittes (2) auf den Schritt (1) folgt.

11. Verfahren nach Anspruch 9 oder 10, **dadurch gekennzeichnet, dass** das Substrat A nach einem der Trocknungs-, Polymerisations- und/oder Vernetzungsschritte (3) entfernt wird, bevorzugt nach dem letzten Schritt (3).

12. Verwendung einer Konversionsfolie nach einem der Ansprüche 1 bis 8 zur Ausrüstung von lichtemittierenden Elementen.

13. Vorrichtung enthaltend ein lichtemittierendes Element, **dadurch gekennzeichnet, dass** das lichtemittierende Element durch mindestens eine Konversionsfolie nach einem der Ansprüche 1 bis 8 abgedeckt ist.

14. Vorrichtung nach Anspruch 13, **dadurch gekennzeichnet, dass** sie zusätzlich eine oder mehrere transluzente Farbschichten aufweisende Folien enthält.
